# EUROPEAN PATENT APPLICATION

(11) **EP 0 613 963 A1**
(43) Date of publication of application: **07.09.1994**
(21) Application number: 94301420.9
(22) Date of filing: 28.02.1994
(51) Int. Cl.: C23C 16/26, C23C 16/04, C23C 16/02

(54) **Production of crack-free CVD diamond articles**

(30) Priority: 05.03.1993 US 26652
(71) Applicant: GENERAL ELECTRIC COMPANY, Schenectady, NY 12345 (US)
(72) Inventor: Williams, Bradley Earl, Worthington, Ohio 43085 (US); Kosky, Philip George, Schenectady, New York 12309 (US)
(74) Representative: Pratt, Richard Wilson

(57) **Abstract**

Cracking of diamond sheets deposited by chemical vapor deposition on substrates such as niobium is sometimes observed as a result of curling of the diamond around the edges of the substrate. Such curling is inhibited by employing a substrate with edges of a metal promoting the formation of graphite. Illustrative graphite-promoting metals are iron, nickel and platinum.

## Description

This invention relates to the chemical vapor deposition of diamond, and more particularly to the deposition of diamond films and sheets capable of clean release from the substrates on which they are deposited.

The preparation of diamond articles by chemical vapor deposition is increasingly important in commerce. It is particularly useful for the production of polycrystalline diamond films and sheets.

In the chemical vapor deposition method, a substrate capable of receiving a diamond deposit is contacted with an activated mixture of hydrogen and a hydrocarbon gas. Activation may be, for example, by thermal, microwave or plasma means or combinations thereof. The result of the activation is production of atomic hydrogen which converts the hydrocarbon to diamond crystals which deposit on the surface of the substrate, forming a polycrystalline diamond layer which is in the form of a planar film or sheet when the substrate is planar.

It is frequently useful to separate the diamond film or sheet from the substrate. This is true, for example, when diamond is to be employed as a heat sink in an electronic device or the like. The separated film or sheet may then be cut, typically by laser action, into a number of segments of the desired size.

The releasability of diamond layers from substrates depends to a large extent on the substrate material employed. It is frequently found that the diamond adheres more or less tenaciously to the substrate. This may cause fracturing of the diamond upon cool-down after formation or upon removal. Said fracturing may be in the form of shattering (which makes the diamond totally useless) or by cracking (which reduces its useful size).

In copending, commonly owned application EP-A-0546752, there is disclosed a genus of substrates which promote releasability of the diamond coatings produced thereon. These substrates comprise hydride-forming metals such as niobium. When the combined substrate and diamond layer are cooled after deposition of the diamond, the latter is easily released. This is particularly true if hydrogen flow is continued during the cooling operation, which is believed to result in the formation of a hydride layer which further promotes diamond removal.

Even with the use of such substrate materials, however, cracking is sometimes noted. This is frequently the result of the tendency of the diamond to grow or "curl" around one or more edges of the substrate, impeding release. There is also frequently a large difference between the coefficients of thermal expansion of the substrate and the diamond layer, which puts stress on the diamond curled around the edge of the substrate upon cool-down and causes cracking, often extending over a large proportion of the film or sheet.

The present invention is based on the discovery that a number of materials promote graphite formation as an alternative to diamond formation. If these materials are present in edge regions of the substrate, the growth of the diamond film can be limited to a desired portion of a single substrate surface, with graphite being formed in other regions. It is thus easy to remove the diamond in the form of a monolithic film or sheet, without cracking thereof.

In one of its aspects, the invention includes substrates adapted for chemical vapor deposition of diamond, said substrates comprising a diamond-receiving region of a hydride-forming metal bounded on at least one side by a region of a metal promoting the formation of graphite.

The substrate employed according to the present invention is usually planar, since an important feature of the invention is the production of crack-free planar diamond sheets or films. Other shapes are, however, within the scope of the invention.

Said substrate comprises a diamond-receiving region which is formed of a hydride-forming metal. Such metals include niobium, titanium, zirconium, hafnium, vanadium, tantalum, palladium and alloys thereof. Niobium is often preferred. It is also within the scope of the invention to employ a composite substrate, typically a thick diamond sheet with a thin overlayer of said hydride-forming metal, to minimize differences in thermal expansion between the substrate and the deposited film or sheet.

It is frequently desirable to produce a diamond film or sheet with a highly polished surface. This may be achieved by polishing the diamond-receiving surface by known techniques; e.g., mechanical polishing or electropolishing.

Some hydride-forming metals provide poor nucleation surfaces for diamond growth. Surfaces of such metals can be activated to enhance nucleation. Activation may be achieved by rubbing the surfaces with diamond dust, typically about 1 micron in size, or by applying thereto a suspension of diamond dust in a suitable polar liquid, typically an alcohol, preferably with ultrasonic agitation.

As an essential feature of the invention, the diamond-receiving region of the substrate is bounded on at least one side by a region of a metal promoting the formation of graphite under chemical vapor deposition conditions. Such metals include iron, nickel and platinum, as well as alloys thereof. Nickel is frequently preferred. Most often, the graphite-forming region is present on all sides of a planar substrate surface, to avoid extension of the diamond layer around any edge thereof.

The size of the graphite-forming region is generally not critical; any width thereof (between the diamond-receiving region and the edge of the substrate) will inhibit curl formation. A width of about 0.25-2.0 cm. is typical.

Various methods may be employed for providing the graphite-forming region on the substrate. These include sputtering or electroless or electrolytic deposition. It is often preferred, however, to simply attach a sheet of the substrate metal to a larger sheet or plate of the graphite-receiving metal, attachment being by conventional methods such as soldering or bolting. Under these circumstances, it may be desirable to bevel the substrate surface so as to provide a relatively level junction with the graphite-forming region.

The details of the CVD operation, as well as the equipment and materials used therein, need not be repeated here since they are well known in the art. The process involves the reaction of a hydrocarbon with atomic hydrogen. The essential items are a vessel in which the CVD operation is conducted, typically under reduced pressure; a substrate within said vessel on which the diamond is deposited; means for introducing the reactive gases into said vessel and into contact with the substrate; and activation means to create reactive conditions. A hot filament, microwave generator or plasma generator, or a combination thereof, is typically employed for activation of the hydrogen-hydrocarbon mixture.

Another aspect of the invention, therefore, is a method for producing a substantially crack-free diamond film or sheet having predetermined boundaries by chemical vapor deposition, said method comprising contacting a substrate with an activated hydrogen-hydrocarbon gas mixture under chemical vapor deposition conditions, said substrate being as described hereinabove.

The invention is illustrated by an example in which a sheet of niobium, 88 x 25 x 6 mm., was fastened to a nickel plate, 102 x 38 mm., and the edges were uniformly beveled at 45°. The top surface and edges were polished and the assembly was pretreated with a slurry of diamond powder in ethanol.

The substrate was mounted in a hot filament chemical vapor deposition apparatus having two tungsten filaments located parallel to the substrate and 10 mm. therefrom, and a mixture of 1 part (by volume) of methane and 99 parts of hydrogen was passed into the chamber at 1 liter per minute. The filaments were resistively heated to 2000°C, maintaining a substrate temperature of about 800°C. Diamond deposition was continued for 7 days, after which the power to the filaments was gradually decreased and finally turned off.

A diamond film was observed on the treated niobium surfaces. On the nickel surfaces, on the other hand, only graphitic soot was formed; it was easily wiped off, leaving a substantially flat diamond film which released crack-free from the niobium surface.

## Claims

1. A substrate adapted for chemical vapor deposition of diamond, said substrate comprising a diamond-receiving region of a hydride-forming metal bounded on at least one side by a region of a metal promoting the formation of graphite.

2. A method for producing a substantially crack-free diamond film or sheet having predetermined boundaries by chemical vapor deposition which comprises contacting a substrate with an activated hydrogen-hydrocarbon gas mixture under chemical vapor deposition conditions, said substrate comprising a diamond-receiving region of a hydride-forming metal bounded on at least one side by a region of a metal promoting the formation of graphite.

3. The invention according to Claim 1 or Claim 2 wherein the substrate is planar.

4. The invention according to Claim 3 wherein the diamond-receiving region is bounded on all sides by the graphite-promoting region.

5. The invention according to Claim 1 or Claim 2 wherein the hydride-forming metal is at least one of niobium, titanium, zirconium, hafnium, vanadium, tantalum and palladium.

6. The invention according to Claim 5 wherein the diamond-receiving region is niobium.

7. The invention according to Claim 1 or Claim 2 wherein the diamond-receiving region is polished.

8. The invention according to Claim 1 or Claim 2 wherein the diamond-receiving region is activated to enhance diamond nucleation thereon.

9. The invention according to Claim 1 or Claim 2 wherein the metal promoting graphite formation is at least one of iron, nickel and platinum.

10. The invention according to Claim 9 wherein the metal promoting graphite formation is nickel.
